(19) Europäisches Patentamt
European Patent Office
Office européen des brevets

(11) **EP 0 498 013 B1**

(12) **EUROPÄISCHE PATENTSCHRIFT**

(45) Veröffentlichungstag und Bekanntmachung des Hinweises auf die Patenterteilung:
**04.11.1998 Patentblatt 1998/45**

(51) Int Cl.$^6$: **G06F 1/03**, H03B 21/00

(21) Anmeldenummer: **91101707.7**

(22) Anmeldetag: **07.02.1991**

(54) **Schaltungsanordnung zum Erzeugen eines Taktsignales mit einem Phasenrechenwerk**

Circuit arrangement for generating a clock signal with a phase calculating unit

Dispositif pour produire un signal d'horloge à l'aide d'une unité de calcul de phase

(84) Benannte Vertragsstaaten:
**DE ES FR GB IT**

(43) Veröffentlichungstag der Anmeldung:
**12.08.1992 Patentblatt 1992/33**

(73) Patentinhaber: **SIEMENS AKTIENGESELLSCHAFT**
**80333 München (DE)**

(72) Erfinder: **Kramer, Ronalf, Dipl.-Ing.**
**W-8000 München 60 (DE)**

(56) Entgegenhaltungen:
**EP-A- 0 078 588          EP-A- 0 440 283**

**Beschreibung**

Die Erfindung betrifft eine Schaltungsanordnung zum Erzeugen eines Taktsignales mit einem Phasenrechenwerk nach dem Oberbegriff des Anspruches 1.

Eine Schaltungsanordnung zum Erzeugen eines Taktsignals mit einem Phasenrechenwerk ist beispielsweise aus Elektronik 5./6.3. 1987, Seite 105 bis 108, und aus der DE 34 32 314 A1 bekannt. Zur Erzeugung des Taktsignales dienen zwei PLL-Schaltungen mit jeweils einem sogenannten DTO (Discrete Time Oscillator). Ein solcher DTO erzeugt eine Referenzschwingung, die sowohl amplituden- als auch zeitdiskretisiert ist.

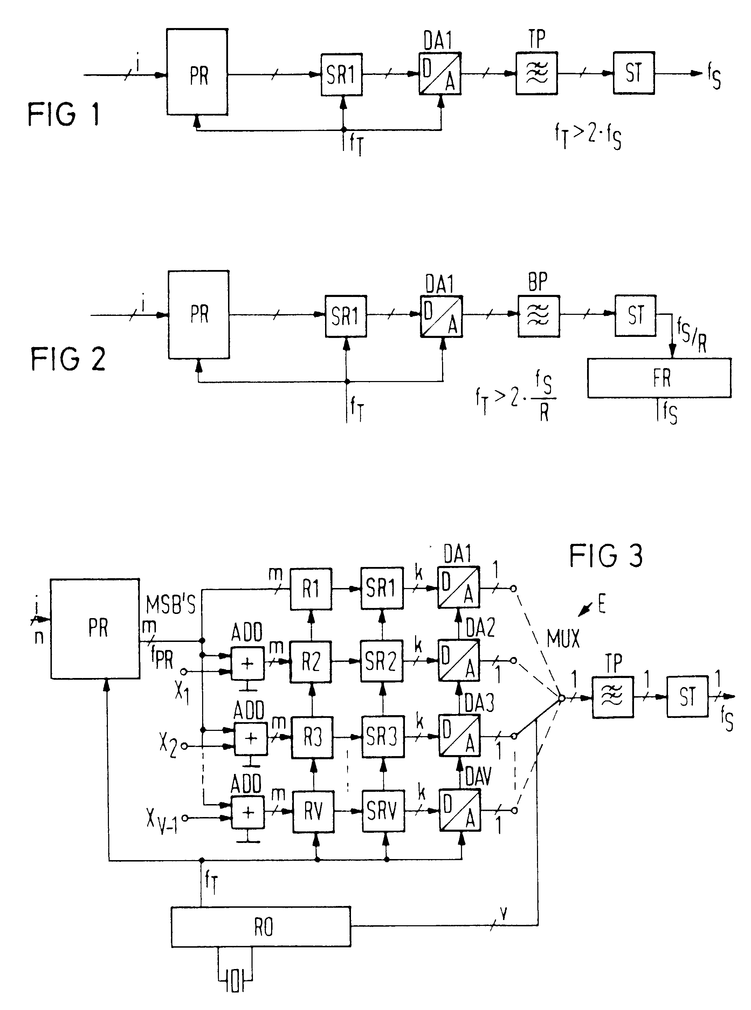

PLL-Schaltungen mit solchen DTOs als steuerbare Oszillatoren müssen eine Taktfrequenz mit hoher Frequenzstabilität und kleinem Phasenjitter erzeugen können. Der Phasenjitter muß insbesondere bei der Demodulation von Videosignalen in einer Größenordnung von maximal 3 nsec gehalten werden, um ein Zittern von vertikalen Bildkanten im Fernsehbild zu vermeiden. Erreicht wird dies bisher prinzipiell auf zwei verschiedenen Möglichkeiten, die in den FIG 1 und 2 dargestellt sind.

In FIG 1 wird einem Phasenrechenwerk PR ein konstantes digitales Signal, das sogenannte Inkrement i, Takt für Takt einer Abtastfrequenz $f_T$ aufakkumuliert. Am Ausgang des Phasenrechenwerks PR entsteht eine sägezahnförmige Folge von Phasenabtastwerten für ein Sinussignal mit einer Frequenz $f_{PR}$ mit einer durch die Abtastfrequenz $f_T$ bestimmten Folgefrequenz. In einer nachfolgenden Umcodiereinrichtung SR1, die beispielsweise ein sin-ROM oder ein Trapez-ROM aufweisen kann, wird aus diesen Phasenabtastwerten eine Folge von Amplitudenabtastwerten eines Sinussignales bzw. Trapezsignales mit der Frequenz $f_S$ gebildet. An den Ausgang der Umcodiereinrichtung SR1 ist ein Digital-Analog-Wandler DA1 geschaltet, um aus der Folge von Amplitudenabtastwerten ein kontinuierliches treppenförmiges Signal zu bilden. In einer nachgeschalteten Filtereinrichtung TP, hier ein analoger Tiefpaß, dessen Grenzfrequenz größer als die Frequenz $f_S$ sein muß, wird aus dem treppenförmigen Signal ein sinusförmiges Signal gebildet. Ausgangsseitig ist zweckmäßigerweise ein Schmitt-Trigger-Einrichtung ST vorgesehen, an deren Ausgang das Taktsignal mit der Frequenz $f_S$ abgreifbar ist. Dieses Taktsignal mit der Frequenz $f_S$ dient beispielsweise als Referenzträger bei der Demodulation von Chrominanzsignalen in einem Fernsehgerät.

Der Phasenjitter in der digitalen PLL mit einem solchen DTO ist umso kleiner, je höher die Abtastfrequenz $f_T$ gewählt ist, mit der das Phasenrechenwerk PR, die Umcodiereinrichtung SR1 und der Digital-Analog-Wandler getaktet werden. Die Abtastfrequenz $f_T$ muß mindestens größer als 2 . $f_S$ sein.

Eine zweite Möglichkeit eine hohe Frequenzstabilität und geringen Phasenjitter in der PLL zu gewährleisten, besteht in einer Anordnung, wie diese in FIG 2 dargestellt ist. Diese Schaltungsanordnung unterscheidet sich von der in FIG 1 vorgestellten Schaltungsanordnung insbesondere dadurch, daß jetzt ausgangsseitig an die Schmitt-Trigger-Einrichtung ST eine Frequenzvervielfachungsstufe FR geschaltet ist, die das Taktsignal am Ausgang der Schmitt-Trigger-Einrichtung ST um einen Faktor V erhöht. Im allgemeinen ist eine solche Frequenzvervielfachungsstufe FR eine analoge PLL. Als Filtereinrichtung dient ein analoger Bandpaß BP, dessen Mittenfrequenz um das R-fache kleiner als die Frequenz $f_S$ gewählt ist. Die Abtastfrequenz $f_T$ im DTO muß jetzt lediglich größer als 2 . $\frac{f_S}{R}$ gewählt sein.

Nachteilig bei dieser Schaltungsanordnung ist die Verwendung einer analogen PLL. Bei dieser analogen PLL kann in deren spannungsgesteuerten Oszillator (VCO) wiederum ein Phasenjitter aufgetreten. Darüber hinaus liefert der Ausgang des Digital-Analog-Wandlers DA1 ein verkämmtes Ausgangsspektrum, so daß - wie erwähnt - als Filtereinrichtung ein Bandpaß notwendig ist. Die Verwendung eines solchen Bandpasses BP hat aber zwangsweise zur Folge, daß die Signalfrequenz $f_S$ nur eingeschränkt variierbar ist.

In der EP-A-0 078 588 ist eine Schaltungsanordnung zur Signalerzeugung beschrieben, bei der ein digitales Eingangssignal mehreren Sinusgeneratoren zugeführt wird. Die Ausgänge der Sinusgeneratoren sind über einen Multiplexer mit einem Digital-Analog-Wandler verbunden. Das analoge Ausgangssignal des Wandlers, das in der zu erzeugenden Wellenform vorliegt, wird zunächst in einem Low-Pass-Filter gefiltert, bevor es auf den Ausgang der Schaltungsanordnung gegeben wird.

Der Erfindung liegt die Aufgabe zugrunde, eine andere Möglichkeit für eine Schaltungsanordnung zum Erzeugen einer Taktfrequenz mit einem Phasenrechenwerk anzugeben, die sich durch eine hohe Frequenzstabilität und einen kleinen Phasenjitter auszeichnet. Zusätzlich soll die Schaltungsanordnung die Verwendung einer einfachen Filtereinrichtung ermöglichen.

Diese Aufgabe wird durch die kennzeichnenden Merkmale des Anspruchs 1 gelöst.

Weiterbildungen der Erfindung sind Gegenstand der Unteransprüche.

Die Erfindung wird im folgenden anhand von weiteren sieben Figuren näher erläutert. Es zeigen:

FIG 3  ein Blockschaltbild einer erfindungsgemäßen Schaltungsanordnung mit v identischen Umcodiereinrichtungen, (v-1) Modulo-m-Addiereinrichtungen sowie eine Multiplexereinrichtung, die zwischen die Ausgänge der an die Umcodiereinrichtungen geschalteten Digital-Analog-Wandler und eine Filtereinrichtung geschaltet ist,

FIG 4  ein Blockschaltbild nach FIG 3, jedoch mit nur zwei Umcodiereinrichtungen und einer Modulo-m-Addiereinrichtung,

FIG 5  ein Blockschaltbild nach FIG 4, jedoch mit einer zwischen die beiden Digital-Analog-Wandler und die Filtereinrichtung geschalteten Stromadditionsstufe,

FIG 6 Signalverläufe zur Schaltungsanordnung von FIG 4, wenn in den Umcodiereinrichtungen Sinusverläufe mit einer Frequenz gespeichert sind, die zur Frequenz $f_{PR}$ am Ausgang des Phasenrechenwerkes identisch ist,

FIG 7 Signalverläufe zur Schaltungsanordnung von FIG 4, wenn in den Umcodiereinrichtungen Sinusverläufe mit einer Frequenz gespeichert sind, die dreimal größer ist, als die Frequenz $f_{PR}$ am Ausgang des Phasenrechenwerkes,

FIG 8 ein Blockschaltbild einer erfindungsgemäßen Schaltungsanordnung mit vier verschiedenen Umcodiereinrichtungen ohne Modulo-m-Addiereinrichtungen, und

FIG 9 den prinzipiellen Signalverlauf zur Schaltungsanordnung von FIG 8, wenn nur zwei verschiedene Umcodiereinrichtungen verwendet werden.

In FIG 3 ist ein Blockschaltbild einer erfindungsgemäßen Schaltungsanordnung zum Erzeugen eines Taktsignales mit einem Phasenrechenwerk PR dargestellt, an dessen Ausgang in Abhängigkeit eines digitalen Eingangssignales i, das das Inkrement darstellt, eine sägezahnförmige Folge von Phasenabtastwerten für ein Sinussignal mit der Frequenz $f_{PR}$ abgreifbar ist. Die Folgefrequenz ist durch eine Abtastfrequenz $f_T$ bestimmt. Das Phasenrechenwerk PR weist in an sich bekannter Weise einen Modulo-Addierer MA auf, dessen erstem Eingang das Inkrement i zugeführt wird. Der Ausgang dieses Modulo-Addierers MA ist mit einem Eingang eines Registers R verbunden, an dessen Ausgang die Phasenabtastwerte abgreifbar sind. Diese Phasenabtastwerte werden zum einen einem zweiten Eingang des Modulo-Addierers MA und zum anderen über ein Register R1 einer ersten Umcodiereinrichtung SR1 zugeführt, die vorzugsweise ein sin-ROM aufweist. Der Ausgang dieser Umcodiereinrichtung SR1 ist mit einem ersten Digital-Analog-Wandler DA1 in Verbindung, dessen Ausgang wiederum über eine noch später zu erläuternde Einrichtung E an die Eingangsklemme einer Filtereinrichtung TP, vorzugsweise ein Tiefpaß, geschaltet ist. Der Ausgang der Filtereinrichtung TP kann mit einer Schmitt-Triggereinrichtung ST in Verbindung stehen. An einer Ausgangsklemme dieser Schmitt-Triggereinrichtung ST ist das zu erzeugende Taktsignal mit einer Frequenz $f_S$ abgreifbar. Zweckmäßigerweise wird zwischen das Phasenrechenwerk PR und die Umcodiereinrichtung SR1 ein Register R1 geschaltet.

In FIG 3 sind zusätzlich die Bitbreiten der digitalen Signale auf den dazugehörigen Leitungen angegeben. Das Inkrement i hat eine Bitbreite n, z. B. 18 Bit. Am Ausgang des Phasenrechenwerkes PR werden die m höherwertigsten Bits abgegriffen und über das Register R1 der Umcodiereinrichtung SR1 zugeführt. Am Ausgang der Umcodiereinrichtung SR1 steht ein k breites digitales Signal zur Verfügung, das die Amplitudenabtastwerte diskretisiert an den Digital-Analog-Wandler DA1 weitergibt. Am Ausgang des Digital-Analog-Wandlers DA1 steht ein analoges Signal zur Verfügung, so wie es andeutungsweise durch die Ziffer 1 auf der Ausgangsleitung dieses Digital-Analog-Wandlers DA1 symbolisiert ist. Zur taktweisen Verarbeitung der digitalen Signale wird dem Phasenrechenwerk PR, dem Register R1, der Umcodiereinrichtung SR1 und dem Digital-Analog-Wandler DA1 ein Taktsignal mit einer Abtastfrequenz $f_T$ zugeführt, das aus einem Quarzoszillator, vorzugsweise einem Ringoszillator RO, gewonnen wird. Diese beschriebene Schaltungsanordnung entspricht bisher der Schaltungsanordnung von FIG 1 für einen DTO.

Erfindungsgemäß wird diese Schaltungsanordnung durch weitere (v-1) Umcodiereinrichtungen (SR2...SRv) erweitert, die jeweils parallel zwischen dem Phasenrechenwerk PR und der Filtereinrichtung TP angeordnet sind. Durch diese (v-1) Umcodiereinrichtungen SR2...SRv können weitere unterschiedliche Folgen von Amplitudenabtastwerten des Sinussignales erzeugt werden, wobei v=2,3,4.... ist . Ausgangsseitig sind diese (v-1) Umcodiereinrichtungen SR2...SRv mit jeweils einem Digital-Analog-Wandler DA2....DAv verbunden, deren Ausgänge über die Einrichtung E, die beispielsweise eine Multiplexereinrichtung sein kann, zyklisch abwechselnd an die Filtereinrichtung TP schaltbar sind.

Die unterschiedlichen Folgen von Amplitudenabtastwerten an den Ausgängen der Umcodiereinrichtungen SR2...SRv werden auf folgende Weise erzeugt. Der Ausgang des Phasenrechenwerkes PR wird jeweils einem ersten Eingang einer Modulo-m-Addiereinrichtung ADD zugeführt, deren Ausgang über ein entsprechendes Register R2...Rv mit einem Eingang der entsprechenden Umcodiereinrichtung SR2...SRv in Verbindung steht. Einem jeweils zweiten Eingang dieser Modulo-m-Addiereinrichtung ADD wird ein Korrekturwert X zugeführt. Dieser Wert X ergibt sich aus

$$X_j = 2^m \cdot \frac{f_{PR}}{f_T} \cdot \frac{1}{v} \cdot j$$

wobei m = die Bitbreite des digitalen Signales am Ausgang des Phasenrechenwerkes PR bzw. am Eingang der entsprechenden Umcodiereinrichtung SR2...SRv ist und j = 1....v-1 ist, wenn weitere (v-1) Umcodiereinrichtungen vorgesehen werden.

Bei der in FIG 3 dargestellten Schaltungsanordnung zur Erzeugung des Taktsignales mit dem Phasenrechenwerk PR sind sämtliche Umcodiereinrichtungen SR1...SRv identisch ausgebildet, d. h. daß in diesen Umcodiereinrichtungen SR1...SRv die gleichen Signalverläufe abgespeichert sind. Diese Signalverläufe sind vorzugsweise Sinusverläufe bzw. trapezförmige Signalverläufe.

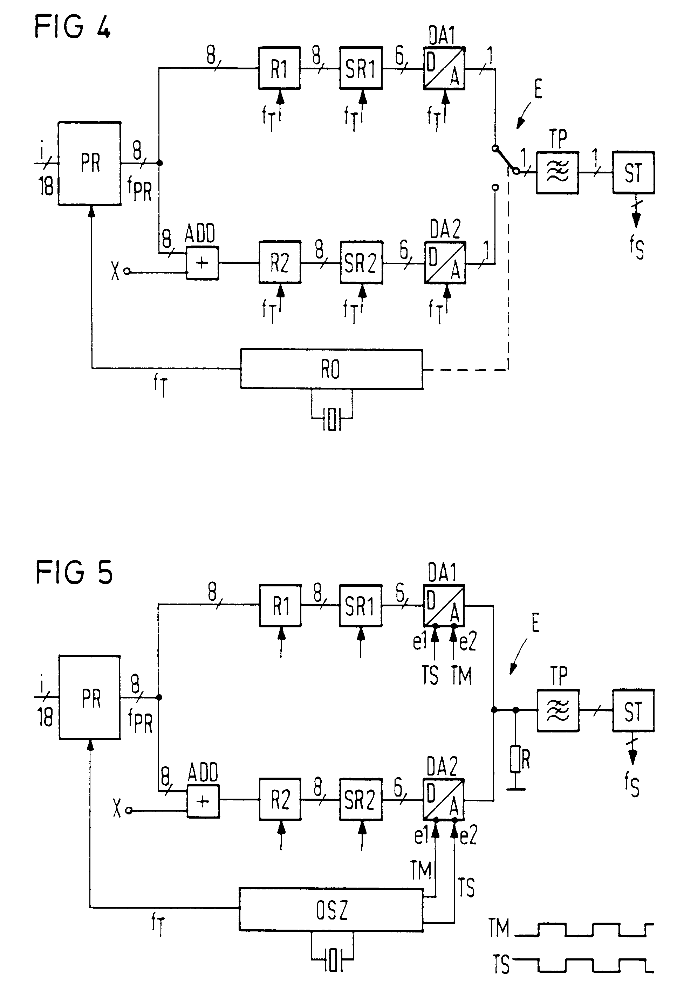

Das Prinzip dieser Schaltungsanordnung wird anhand eines Beispieles im Zusammenhang mit FIG 4 deutlich. Wenn $j = 1$, $n = 18$, $m = 8$, $k = 6$ gewählt ist, ergibt sich für den Wert X bei $v = 2$ (2-fach Überabtastung), folgende Gleichung:

$$X_1 = 2^8 \cdot \frac{f_{PR}}{f_T} \cdot \frac{1}{2}$$

Da allgemein gilt

$$f_{PR} = i \cdot \frac{f_T}{2^n}$$

lassen sich die Werte $X_j$ aus dem Inkrement i gewinnen durch

$$X_j = 2^m \cdot i \cdot \frac{f_T}{2^n} \cdot \frac{1}{f_T} \cdot \frac{1}{v} \cdot j$$

oder

$$X_j = 2^{(m-n)} \cdot i \cdot \frac{1}{V} \cdot j.$$

Damit gilt für das Beispiel:

$$X_1 = 2^{-11} \cdot i.$$

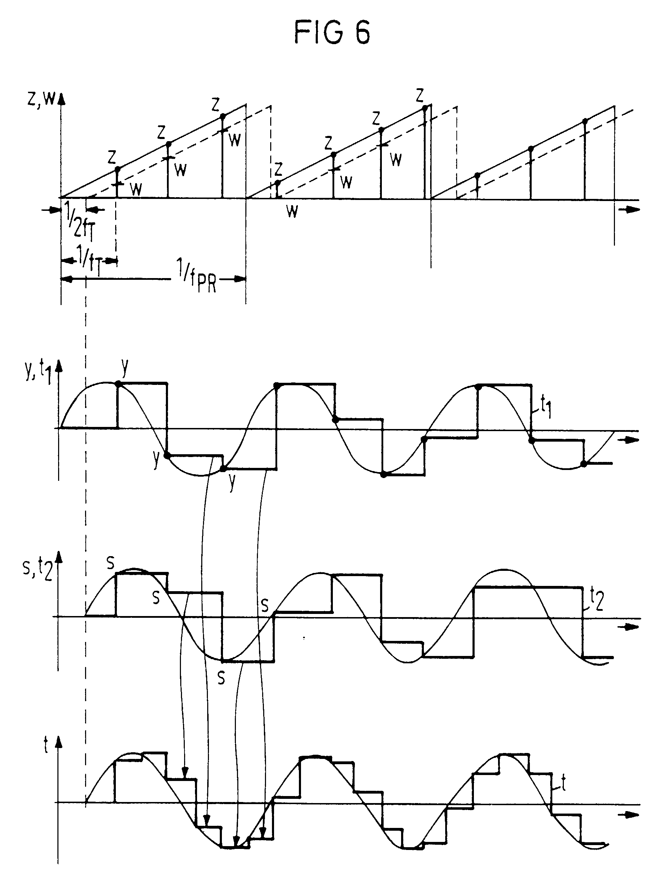

Der Wert $X_1$ stellt einen Versatz im digitalen Eingangswert der Umcodierungseinrichtung SR2 dar. Die Wirkungsweise dieses Versatzes wird anhand der Signalverläufe in FIG 6 erläutert.

In FIG 6 ist die sägezahnförmige Folge von Phasenabtastwerten z für ein Sinussignal mit der Frequenz $f_{PR}$ mit der durch die Abtastfrequenz $f_T$ bestimmten Folgefrequenz dargestellt. Diese Phasenabtastwerte z werden in der Umcodiereinrichtung SR1 zu einer Folge von Amplitudenabtastwerten y eines Sinussignales mit der Frequenz $f_S$ umgeformt. Es sei angenommen, daß in der Umcodiereinrichtung SR1 und in der Umcodiereinrichtung SR2 die gleichen Sinusverläufe gespeichert sind, wobei hier beispielsweise die Sinusverläufe eine Frequenz $f_S$ aufweisen, die gleich der Frequenz $f_{PR}$ des Sinussignals ist, das durch die Phasenabtastwerte z am Ausgang des Phasenrechenwerkes PR bestimmt ist. Diese Folge von Amplitudenabtastwerten y werden durch den Digital-Analog-Wandler DA1 in ein treppenförmiges Signal $t_1$ gewandelt.

Die Modulo-8-Addiereinrichtung ADD führt mit seinen beiden Eingangssignalen, zum einen den Phasenabtastwerten z des Phasenrechenwertes PR sowie zum anderen dem Wert X, zu einem Versatz im digitalen Eingangswert der Umcodiereinrichtung SR2. Damit erhält man eine gegenüber den Phasenabtastwerten z am Ausgang des Phasenrechenwerkes PR zeitlich um $\frac{1}{2} \cdot f_T$ versetzte sägezahnförmige Folge von Phasenabtastwerten w, aus denen sich sogenannte "virtuelle Zwischenabtastwerte" am Ausgang der Umcodiereinrichtung SR2 gewinnen lassen.

Im Signalverlauf von FIG 6 sind die Amplitudenabtastwerte am Ausgang der Umcodiereinrichtung SR2 mit s und das dazugehörende treppenförmige Signal am Ausgang des Digital-Analog-Wandlers DA2 mit $t_2$ gekennzeichnet. Die beiden treppenförmigen Signale $t_1$ und $t_2$ werden über die Einrichtung E, die hier im einfachsten Fall ein Umschalter ist, abwechselnd an die Filtereinrichtung TP geschaltet. Gesteuert wird die Einrichtung E vom Ringoszillator RO, der die Ausgänge der beiden Digital-Analog-Wandler DA1, DA2 zyklus abwechselnd für die Dauer $\frac{1}{v \cdot f_T}$ der Filtereinrichtung TP zuführt, hier also für die Dauer $\frac{1}{2 \cdot f_T}$. Die Einrichtung E wird dabei so gesteuert, daß sich der in FIG 6 dargestellte Verlauf eines treppenförmigen Signales ergibt, dessen Stufenbreite sich allgemein durch $\frac{1}{v \cdot f_T}$ und hier durch $\frac{1}{2 \cdot f_T}$ ergibt. Ergebnis ist ein treppenförmiges Signal t, das im Vergleich zum treppenförmigen Signal $t_1$ am Ausgang des Digital-Analog-Wandlers DA1 eine doppelt so hohe zeitliche Auflösung besitzt. Das treppenförmige Signal t setzt sich aus den beiden treppenförmigen Signalen $t_1$ und $t_2$ derart zusammen, daß für die Dauer $\frac{1}{2 \cdot f_T}$ nach Erscheinen eines Phasenabtastwertes z bzw. eines Amplitudenabtastwertes y der Filtereinrichtung TP der Kurvenverlauf des treppenförmigen Signales $t_2$ am Ausgang des Digital-Analog-Wandlers DA1 zugeführt wird. Für die Dauer $\frac{1}{2 \cdot f_T}$ unmittelbar vor einem solchen Phasenabtastwert z bzw. Amplitudenabtastwertes y wird dagegen der Filtereinrichtung TP der Signalverlauf des treppenförmigen Signales $t_1$ zugeführt.

Mit einer derartigen Schaltungsanordnung ist also eine "virtuelle" 2-fach Überabtastung möglich, indem die Phasenabtastwerte z am Ausgang des Phasenrechenwerkes PR mehrfach, hier im Ausführungsbeispiel von FIG 4 zweifach, ausgenutzt werden.

FIG 5 zeigt eine andere Möglichkeit, wie die Einrichtung E zum Bilden des treppenförmigen Signales t realisiert sein kann. Dazu werden jetzt Digital-Analog-Wandler DA1, DA2 verwendet, die jeweils eine erste und zweite Takteingangsklemme $e_1$, $e_2$ zum Anlegen eines ersten und zweiten Taktsignales TM, TS aufweisen. Diese ersten und zweiten Taktsignale TM, TS, die im allgemeinen als Master-Takt und Slave-Takt bezeichnet werden, sind den beiden Digital-Analog-Wandlern DA1, DA2 an ihren ersten und zweiten Eingangsklemmen $e_1$, $e_2$ vertauscht zuzuführen. Das heißt in diesem Ausführungsbeispiel, daß das erste Taktsignal TM der Eingangsklemme $e_1$ des Digital-Analog-Wandlers DA2 und der zweiten Eingangsklemme $e_2$ des Digital-Analog-Wandlers DA1 zuzuführen ist. Das zweite Taktsignal TS wird der zweiten Eingangsklemme $e_2$ des Digital-Analog-Wandlers DA2 und der ersten Eingangsklemme $e_1$ des Digital-Analog-Wandlers DA1 zugeführt. Die Ausgangsklemmen der Digital-Analog-Wandler DA1, DA2 können dann an eine die Einrichtung E bildende Stromadditionsstufe geschaltet werden. Diese Stromadditionsstufe besteht einfach darin, daß die beiden Ausgänge der Digital-Analog-Wandler DA1, DA2 miteinander verbunden und an eine Klemme eines Widerstandes R geschaltet sind, dessen andere Klemme auf Bezugspotential liegt. Der Verbindungspunkt der beiden Digital-Analog-Wandler DA1, DA2 ist an den Eingang der Filtereinrichtung TP geschaltet.

Bisher wurde davon ausgegangen, daß in den Umcodiereinrichtungen SR1, SR2 von FIG 4 Sinusverläufe oder sinusähnliche Signalverläufe gespeichert sind, deren Frequenz identisch zur Frequenz $f_{PR}$ des Phasenrechenwerkes PR ist. In den Umcodiereinrichtungen SR1, SR2 können jedoch auch Sinusverläufe oder sinusähnliche Signalverläufe mit ganzzahlig Vielfachen der Frequenz $f_{PR}$ des Phasenrechenwerkes PR gespeichert sein, sofern das Abtasttheorem

$$f_T > 2 \cdot \frac{f_S}{v}$$

erfüllt bleibt.

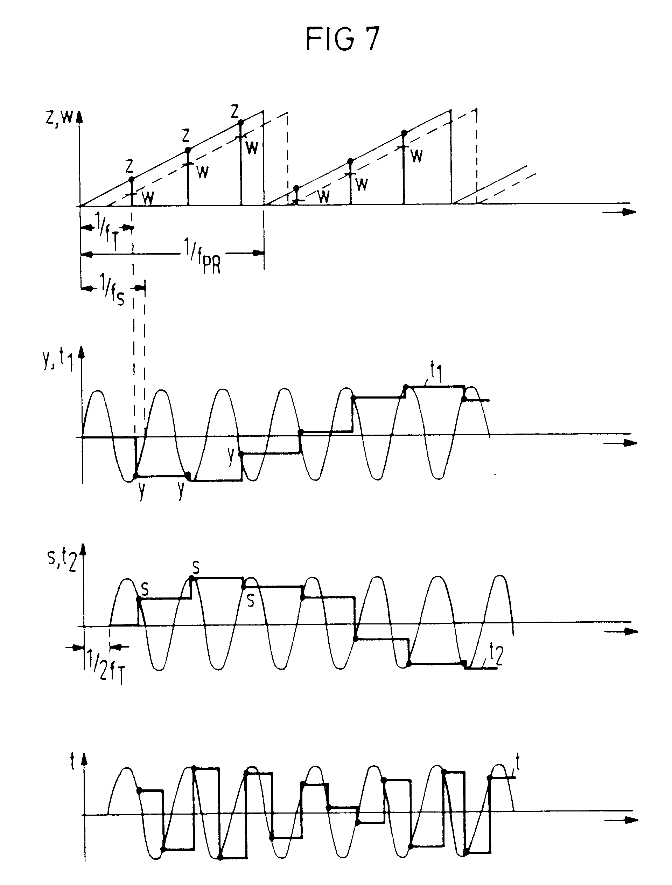

FIG 7 zeigt dies anhand einer Schaltungsanordnung von FIG 4, bei der in den beiden Umcodiereinrichtungen SR1, SR2 Sinusverläufe gespeichert sind, die um das Dreifache größer sind, als die Frequenz $f_{PR}$ des Phasenrechenwerkes PR. Die bereits aus FIG 6 bekannten Bezugszeichen werden in ihrer gleichen Bedeutung in FIG 7 weiterverwendet. Es ist deutlich zu erkennen, daß das treppenförmige Signal t am Eingang der Filtereinrichtung TP einen Sinusverlauf mit der Frequenz $3 \cdot f_{PR}$ repräsentiert, das - wegen v=2 - scheinbar mit der zweifachen Abtastfrequenz $f_T$ abgetastet wurde.

Wird das Verhältnis der Frequenz $f_S$ des Taktsignales zur Frequenz $f_{PR}$ am Ausgang des Phasenrechenwerkes PR gleich $2^k$, wobei k eine ganze Zahl größer gleich 1 ist, so müssen den Umcodiereinrichtungen SR1, SR2 nicht digitale Signale mit der ursprünglich vorgesehenen Bitbreite m zugeführt werden. Es kann vielmehr die Bitbreite um $1d \frac{f_S}{f_{PR}}$ Bit reduziert werden. Dies ist deswegen möglich, da bei einem derartigen Verhältnis der beiden Frequenzen zueinander der Sinusverlauf $2^k$ mal je Periode in der Frequenz $f_{PR}$ des Phasenrechenwerkes PR vorkommt. Dadurch lassen sich nochmal die k höherwertigsten Bits der m-Bit am Ausgang des Phasenwerkes PR einsparen, ohne die effektive Phasenauflösung zu verringern. Allgemein gilt für die reduzierte Bitbreite m'

$$m' = (m - 1d \frac{f_S}{f_{PR}}) \text{ Bit, falls } \frac{f_S}{f_{PR}} = 2^k \text{ ist,}$$

wenn mit m die Bitbreite des digitalen Signales am Einang der Umcodiereinrichtungen bezeichnet wird.

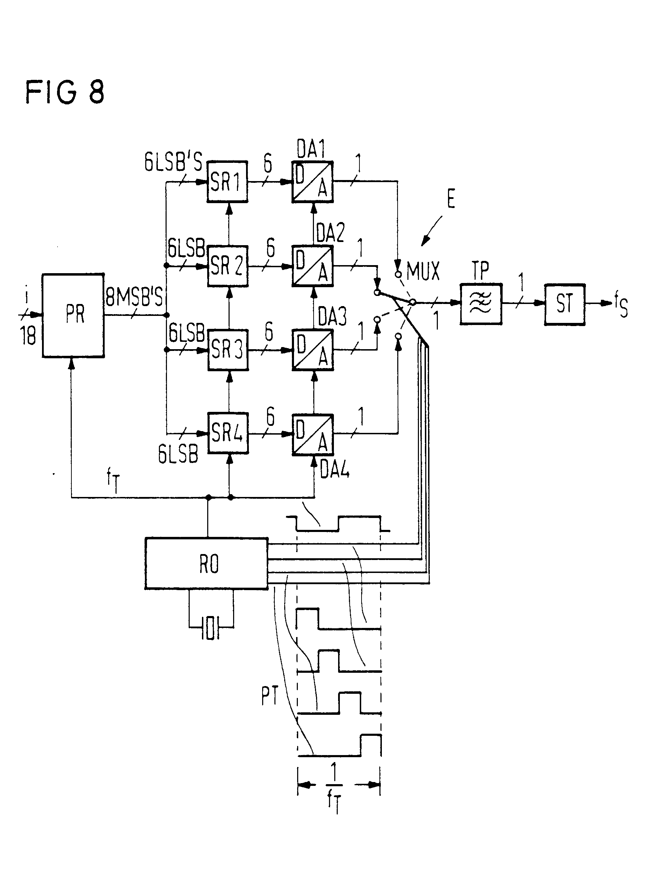

Eine andere Möglichkeit für eine erfindungsgemäße Schaltungsanordnung zum Erzeugen eines Taktsignales mit einem Phasenrechenwerk zeigt FIG 8 beispielhaft anhand von insgesamt vier Umcodiereinrichtungen SR1, SR2, SR3 und SR4. In diesen Umcodiereinrichtungen SR1, SR2, SR3 und SR4 sind Sinusverläufe gespeichert, die jeweils um ein Viertel der Abtastperiode 1/fr zueinander versetzt sind. An die Ausgänge dieser Umcodiereinrichtungen SR1, SR2, SR3 und SR4 sind jeweils ein Digital-Analog-Wandler DA1, DA2, DA3 und DA4 geschaltet, deren Ausgänge wiederum über die Einrichtung E, hier wieder eine Multiplexereinrichtung MUX, zyklisch abwechselnd für die Dauer $\frac{1}{4 \cdot f_T}$ der Filtereinrichtung TP zugeführt werden, wodurch eine virtuelle vierfach-Überabtastung erreicht wird. Im Gegensatz zu den vorgenannten Schaltungsanordnungen sind die Eingänge der Umcodiereinrichtung SR1, SR2, SR3 und SR4 jeweils ohne Zwischenschaltung eine Addiereinrichtung an den Ausgang des Phasenrechenwerkes PR geschaltet. Da in dieser Schaltungsanordnung wieder angenommen wird, daß $\frac{f_S}{f_{PR}} = 4$ gewählt ist, können die zwei höherwertigsten Bits der Bits am Ausgang des Phasenrechenwerkes PR weggelassen werden. Den Umcodiereinrichtungen SR1, SR2, SR3 und SR4 werden damit nur 6 Bit breite digitale Signale zugeführt. Die Umschaltung der Einrichtung E, also der Multiplexereinrichtung MUX, erfolgt - wie bei den vorgegangenen Schaltungsanordnungen - über einen Quarzoszillator RO, der sowohl die Abtastfrequenz $f_T$ als auch vier um $\frac{1}{4 \cdot f_T}$ zueinander versetzte Phasentakte PT bereitstellt. Der Vorteil dieser Schaltungsanordnung liegt vor allem darin, daß die Modulo-m-Additionseinrichtungen eingespart werden können.

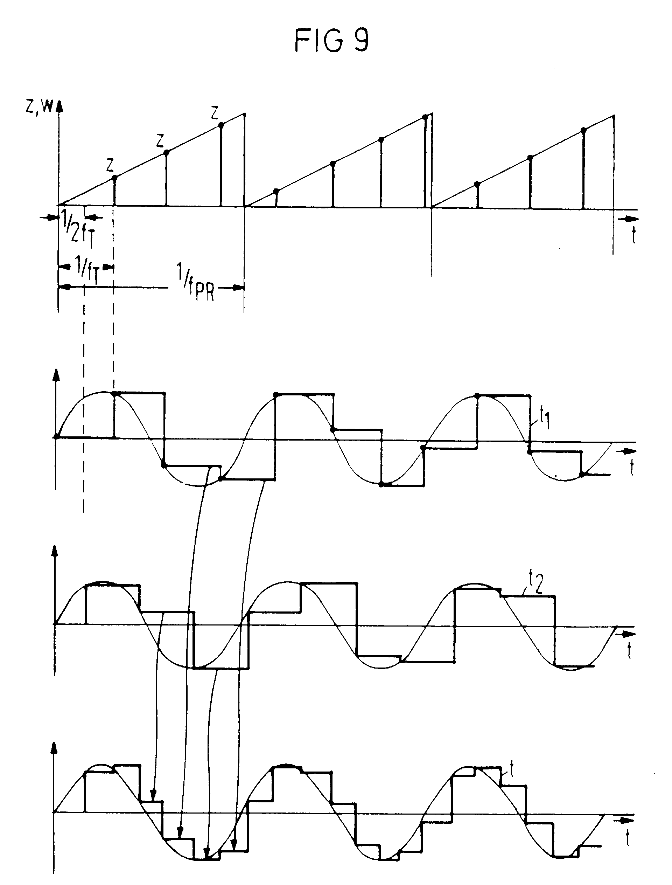

Die prinzipielle Wirkungsweise einer Schaltungsanordnung nach FIG 8 wird anhand von FIG 9 deutlich. Der Einfachheit halber wird angenommen, daß die Schaltungsanordnung nur zwei Umcodiereinrichtungen SR1 und SR2 mit jeweils nachgeschalteten Digital-Analog-Wandlern DA1, DA2 aufweist, deren Ausgänge zyklisch abwechselnd an die Filtereinrichtung TP geschaltet werden. Damit ist V=2. In den beiden Umcodiereinrichtungen SR1 und SR2 sind um eine halbe Abtastperiode der Abtastfrequenz $f_T$ zueinander versetzte Sinusverläufe gespeichert. Die Phasenabtastwerte am Ausgang des Phasenrechenwerkes PR sind wieder mit z bezeichnet. Den Verlauf des treppenförmigen Signales $t_1$ am Ausgang der ersten Umcodiereinrichtung SR1 zeigt der zweite Kurvenverlauf von oben in FIG 9. Darunter ist das treppenförmige Signal $t_2$ am Ausgang der zweiten Umcodiereinrichtung SR2 dargestellt. Werden diese beiden treppenförmigen Signale $t_1$ und $t_2$ der Einrichtung E zugeführt, so ergibt sich der in FIG 9 unten dargestellte Verlauf des treppenförmigen Signales t, das eine Stufenbreite von $\frac{1}{2 \cdot f_T}$ aufweist, wobei die treppenförmigen Signale $t_1$, $t_2$ an den Ausgängen der beiden Digital-Analog-Wandler DA1, DA2 zyklisch abwechselnd jeweils für die Dauer $\frac{1}{2 \cdot f_T}$ der Filtereinrichtung TP zugeführt werden. Die Einrichtung E schaltet derart um, daß nach einem Phasenabtastwert z für die Dauer $\frac{1}{2 \cdot f_T}$ zunächst der Kurvenverlauf des treppenförmigen Signales $t_1$ an die Filtereinrichtung TP gelangt und anschließend der Kurvenverlauf des zweiten treppenförmigen Signales $t_2$ für die Dauer $\frac{1}{2 \cdot f_T}$.

Ergebnis ist wieder ein treppenförmiges Signal t, das im Vergleich zum treppenförmigen Signal $t_1$ am Ausgang des Digital-Analog-Wandlers DA1 eine doppelt so hohe Auflösung aufweist. Entsprechend der Wahl von v kann die Auflösung noch weiter erhöht werden.

Ein besonderer Vorteil der erfindungsgemäßen Schaltungsanordnung liegt darin, daß sich die am Ausgang der Schaltungsanordnung Frequenz $f_S$ des Taktsignales in einem weiten Bereich verändern läßt.

**Patentansprüche**

1. Schaltungsanordnung zum Erzeugen eines Taktsignales mit

   - einem Phasenrechenwerk (PR), an dessen Ausgang in Abhängigkeit eines digitalen Eingangssignales (i) eine sägezahnförmige Folge von Phasenabtastwerten (z) für ein Sinussignal oder sinusähnliches Signal mit der Frequenz $f_{PR}$ mit einer durch eine Abtastfrequenz $f_T$ bestimmten Folgefrequenz abgreifbar ist,
   - einer nachgeschalteten Filtereinrichtung (TP),
   - Umcodiereinrichtungen (SR1...SRv), die jeweils parallel zwischen dem Phasenrechenwerk (PR) und der Filtereinrichtung (TP) angeordnet sind, um aus diesen Phasenabtastwerten (z) unterschiedliche Folgen von Amplitudenabtastwerten (y) eines Sinussignales oder sinusähnlichen Signales mit der Frequenz $f_s$ zu erzeugen, wobei v eine ganze Zahl größer gleich 2 ist, gekennzeichnet durch
   - Digital-Analog-Wandler (DA1...DAv), die jeweils einer der v Umcodiereinrichtungen (SR1...SRv) nachgeschaltet sind, um treppenförmige Signale ($t_1$...$t_v$) zu erzeugen und
   - einer Einrichtung (E) zum Bilden eines treppenförmigen Signales (t) mit einer Stufenbreite von $\frac{1}{v \cdot f_T}$, in dem die treppenförmigen Signale ($t_1$...$t_v$) der Filtereinrichtung (TP) zyklisch abwechselnd jeweils für die Dauer $\frac{1}{v \cdot f_T}$ zuführbar sind, und

   daß sämtliche Umcodiereinrichtungen (SR1..., SRv) unterschiedlich ausgebildet sind, indem in den Umcodiereinrichtungen (SR1...SRv) jeweils um $\frac{1}{v \cdot f_T}$ zueinander versetzte Signalverläufe abgespeichert sind.

2. Schaltungsanordnung nach Anspruch 1,
   **dadurch gekennzeichnet,**

daß zwischen (V-1) Umcodiereinrichtungen (SR2...SRv) und dem Phasenrechenwerk (PR) jeweils eine modulo-m-Addiereinrichtung (ADD) vorgesehen ist, deren Ausgangsklemme mit der entsprechenden Umcodiereinrichtung (SR2...SRv) verbunden ist, deren einer Eingangsklemme die Phasenabtastwerte des Phasenrechenwerkes (PR) und deren andere Eingangsklemme ein Wert X zuführbar ist, und daß sich dieser Wert X aus

$$X_j = 2^m \frac{f_{PR}}{f_t} \cdot \frac{1}{v} \cdot j$$

ergibt, wobei m = Bitbreite eines Signales am Eingang der entsprechenden Umcodiereinrichtung (SR2...SRv) und j = 1, ..., v-1 ist.

3. Schaltungsanordnung nach Anspruch 1 oder 2,
   **dadurch gekennzeichnet,**
   daß die Einrichtung (E) eine Multiplexereinrichtung ist, durch die abwechselnd die Ausgänge der Digital-Analog-Wandler (DA1...DAv) mit einer Schaltfrequenz von $\frac{f_T}{v}$ an die Filtereinrichtung (TP) schaltbar sind.

4. Schaltungsanordnung nach Anspruch 1 oder 2,
   **dadurch gekennzeichnet,**

   daß v=2 gewählt ist,
   daß die beiden Digital-Analog-Wandler (DA1, DA2) jeweils eine erste und zweite Takteingangsklemme ($e_1$, $e_2$) zum Anlegen eines ersten und zweiten Taktsignales (TM, TS) aufweisen, und daß die ersten und zweiten Taktsignale den beiden Digital-Analog-Wandlern an ihren ersten und zweiten Eingangsklemmen vertauscht zuführbar sind, und
   daß die Ausgänge der beiden Digital-Analog-Wandler an eine die Einrichtung (E) bildende Stromadditionsstufe geschaltet sind.

5. Schaltungsanordnung nach einem der Ansprüche 1 bis 4,
   **dadurch gekennzeichnet,**
   daß der Filtereinrichtung (TP) eine Schmitt-Trigger-Einrichtung (ST) nachgeschaltet ist.

6. Schaltungsanordnung nach einem der Ansprüche 1 bis 5,
   **dadurch gekennzeichnet,**
   daß die Filtereinrichtung (TP) eine Tiefpaßeinrichtung ist.

7. Schaltungsanordnung nach einem der Ansprüche 1 bis 6,
   **dadurch gekennzeichnet,**

daß das Verhältnis der Frequenz $f_S$ des Taktsignales zur Frequenz $f_{PR}$ des Phasenrechenwerkes (PR) gleich $2^n$ ist und den Umcodiereinrichtungen (SR1...SRv) digitale Signale mit einer reduzierten Bitbreite zuführbar sind.

8. Schaltungsanordnung nach einem der Ansprüche 1 bis 7,
**dadurch gekennzeichnet,**
daß in den Umcodiereinrichtungen (SR1...SRv) Signalverläufe gespeichert sind, die ein ganzzahlig Vielfaches der Frequenz $f_{PR}$ des Phasenrechenwerkes (PR) sind.

9. Schaltungsanordnung nach einem der Ansprüche 1 bis 3 oder 5 bis 8,
**dadurch gekennzeichnet,**
daß die Abtastfrequenz $f_T$ und die Steuersignale zum Umschalten der Einrichtung (E) von einem Ringoszillator (RO) generierbar sind.

**Claims**

1. Circuit arrangement for generating a clock signal comprising

   - a phase-calculating unit (PR), at the output of which a sawtooth-shaped sequence of phase samples (z) for a sine-wave signal or sinusoidal signal having the frequency $f_{PR}$ with a repetition rate determined by a sampling frequency $f_T$ can be picked up in dependence on a digital input signal (i),
   - a downstream filter device (TP),
   - v code-conversion devices (SR1...SRv) which are in each case arranged in parallel between the phase-calculating unit (PR) and the filter device (TP) in order to generate from these phase samples (z) different sequences of amplitude samples (y) of a sine-wave signal or sinusoidal signal having the frequency $f_s$, v being an integral number greater than or equal to 2, characterized by
   - v digital/analogue converters (DA1...DAv) which are in each case connected downstream of one of the v code-conversion devices (SR1...SRv) in order to generate stairstep-type signals $(t_1...t_v)$, and
   - a device (E) for forming a stairstep-type signal (t) having a step length of $\frac{1}{v \cdot f_T}$, in which the stairstep-type signals $(t_1...t_v)$ can be cyclically alternately supplied to the filter device (TP) in each case for the period $\frac{1}{v \cdot f_T}$ and

   that all code-conversion devices (SR1..., SRv) are of different configuration in that signal variations displaced by $\frac{1}{v \cdot f_T}$ with respect to one another are in each case stored in the code-conversion devices (SR1...SRv).

2. Circuit arrangement according to Claim 1, characterized in that between (V-1) code-conversion devices (SR2...SRv) and the phase-calculating unit (PR), in each case a modulo-m adding device (ADD) is provided, the output terminal of which is connected to the corresponding code-conversion device (SR2...SRv), one input terminal of which can be supplied with the phase samples of the phase-calculating unit (PR) and the other input terminal of which can be supplied with a value X, and that this value X is the result of

$$X_j = 2^m \frac{f_{PR}}{f_t} \cdot \frac{1}{v} \cdot j$$

where m = the bit length of a signal at the input of the corresponding code-conversion device (SR2...SRv) and j = 1, ..., v-1.

3. Circuit arrangement according to Claim 1 or 2, characterized in that the device (E) is a multiplexer device by means of which the outputs of the digital/analogue converters (DA1...DAv) can be alternately switched to the filter device (TP) with a switching frequency of $\frac{f_T}{v}$.

4. Circuit arrangement according to Claim 1 or 2, characterized in that v is selected to be v=2, in that the two digital/analogue converters (DA1, DA2) in each case have a first and second clock input terminal $(e_1, e_2)$ for applying a first and second clock signal (TM, TS), and that the first and second clock signals can be supplied exchanged at their first and second input terminals to the two digital/analogue converters, and that the outputs of the two digital/analogue converters are connected to a current-adding stage forming the device (E).

5. Circuit arrangement according to one of Claims 1 to 4, characterized in that the filter device (TP) is followed by a Schmitt trigger device (ST).

6. Circuit arrangement according to one of Claims 1 to 5, characterized in that the filter device (TP) is a low-pass device.

7. Circuit arrangement according to one of Claims 1 to 6, characterized in that the ratio of the frequency $f_S$ of the clock signal to the frequency $f_{PR}$ of the phase calculating unit (PR) is equal to $2^n$ and digital signals having a reduced bit length can be supplied to the code-conversion devices (SR1...SRv).

8. Circuit arrangement according to one of Claims 1 to 7, characterized in that signal variations which are an integral multiple of the frequency $f_{PR}$ of the phase-calculating unit (PR) are stored in the code-conversion devices (SR1...SRv).

9. Circuit arrangement according to one of Claims 1 to 3 or 5 to 8, characterized in that the sampling frequency $f_T$ and the control signals for switching the device (E) can be generated by a ring oscillator (RO).

**Revendications**

1. Dispositif pour produire un signal d'horloge comprenant

   - une unité de calcul de phase (PR) à la sortie de laquelle, en fonction d'un signal d'entrée numérique (i), une séquence en dents de scie de valeurs échantillonnées de phase (z) pour un signal sinusoïdal ou analogue à un sinus de fréquence $f_{PR}$ peut être prélevée avec une fréquence de séquence déterminée par une fréquence d'échantillonnage $f_T$,
   - un dispositif de filtrage (TP) branché du côté aval,
   - v dispositifs de conversion (SR1 à SRv), qui sont placés à chaque fois en parallèle entre l'unité de calcul de phase (PR) et le dispositif de filtrage (TP), pour produire à partir de ces valeurs échantillonnées de phase (z) séquences différentes de valeurs échantillonnées d'amplitude (y) d'un signal sinusoïdal ou analogue à un sinus de fréquence $f_S$, v étant un nombre entier supérieur ou égal à 2,

   caractérisé

   - par v convertisseurs numériques-analogiques (DA1 à DAv), qui sont branchés chacun du côté aval d'un des v dispositifs de conversion (SR1 à SRv) pour produire des signaux en escalier ($t_1$ à $t_v$) et
   - par un dispositif (E) pour former un signal en escalier (t) avec une largeur d'échelon de $\frac{1}{v \cdot f_T}$, les signaux en escalier ($t_1$ à $t_v$) pouvant être envoyés de façon cyclique et alternée au dispositif de filtrage (PT) à chaque fois pendant la durée $\frac{1}{v \cdot f_T}$, et

   par le fait que tous les dispositifs de conversion (SR1 à SRv) sont conçus différemment, des courbes de signaux décalées à chaque fois de $\frac{1}{v \cdot f_T}$ les unes par rapport aux autres étant mémorisées dans les dispositifs de conversion (SR1 à SRv).

2. Dispositif selon la revendication 1,

caractérisé par le fait que

il est prévu entre (v-1) dispositifs de conversion (SR2 à SRv) et l'unité de calcul de phase (PR) à chaque fois un dispositif additionneur modulo m (ADD) dont la borne de sortie est reliée au dispositif de conversion (SR2 à SRv) correspondant, dont une borne d'entrée peut recevoir les valeurs échantillonnées de phase de l'unité de calcul de phase (PR) et dont l'autre borne d'entrée peut recevoir une valeur X, et cette valeur X est donnée par la relation :

$$X_j = 2^m \frac{f_{PR}}{f_t} \cdot \frac{1}{v} \cdot j$$

m étant la largeur binaire d'un signal présent à l'entrée du dispositif de conversion (SR2 à SRv) correspondant et $j = 1, ..., v-1$.

3. Dispositif selon la revendication 1 ou 2, caractérisé par le fait que le dispositif (E) est un dispositif multiplexeur par lequel les sorties des convertisseurs numériques-analogiques (DA1 à DAv) peuvent être branchées en alternance avec une fréquence de commutation de $\frac{f_T}{v}$ sur le dispositif de filtrage (TP).

4. Dispositif selon la revendication 1 ou 2, caractérisé par le fait que

   v est choisi égal à 2, les deux convertisseurs numériques-analogiques (DA1, DA2) comportent chacun une première et une deuxième borne d'entrée d'horloge ($e_1$, $e_2$) pour appliquer un premier et un deuxième signal d'horloge (TM, TS), et le premier et le deuxième signal d'horloge peuvent être envoyés, permutés, sur les deux bornes d'entrée des deux convertisseurs numériques-analogiques et les sorties des deux convertisseurs numériques-analogiques sont branchées sur un étage additionneur de courant formant le dispositif (E).

5. Dispositif selon l'une des revendications 1 à 4, caractérisé par le fait que un dispositif à Trigger de Schmitt (ST) est branché du côté aval du dispositif de filtrage (TP).

6. Dispositif selon l'une des revendications 1 à 5, caractérisé par le fait que le dispositif de filtrage (TP) est un filtre passe-bas.

7. Dispositif selon l'une des revendications 1 à 6, caractérisé par le fait que

le rapport de la fréquence $f_S$ du signal d'horloge à la fréquence $f_{PR}$ de l'unité de calcul de phase (PR) est égal à $2^n$ et des signaux numériques ayant une largeur binaire réduite peuvent être envoyés aux dispositifs de conversion (SR1 à SRv).

8. Dispositif selon l'une des revendications 1 à 7, caractérisé par le fait que

les courbes de signaux mémorisées dans les dispositifs de conversion (SR1 à SRv) sont un multiple entier de la fréquence $f_{PR}$ de l'unité de calcul de phase (PR).

9. Dispositif selon l'une des revendications 1 à 3 ou 5 à 8,

caractérisé par le fait que

la fréquence d'échantillonnage $f_T$ et les signaux de commande pour la commutation du dispositif (E) peuvent être générés par un oscillateur annulaire (RO).

FIG 1

$f_T > 2 \cdot f_S$

FIG 2

$f_T > 2 \cdot \dfrac{f_S}{R}$

FIG 3

FIG 4

FIG 5

# FIG 6

# FIG 7

# FIG 8

# FIG 9